# DEMANDE DE BREVET EUROPEEN

(11) **EP 3 618 293 A1**
(43) Date de publication de la demande: **04.03.2020**
(21) Numéro de dépôt: 19193486.8
(22) Date de dépôt: 23.08.2019
(51) Int. Cl.: H04B 5/00

(54) **AJUSTEMENT EN FRÉQUENCE D'UN DISPOSITIF DE COMMUNICATION SANS CONTACT**

(30) Priorité: 31.08.2018 FR 1857859
(71) Demandeur: STMicroelectronics (Rousset) SAS, 13790 Rousset (FR)
(72) Inventeur: TRAMONI, Alexandre, 83330 LE BEAUSSET (FR)
(74) Mandataire: Cabinet Beaumont

(57) **Abrégé**

La présente description concerne un dispositif de communication en champ proche comportant un circuit oscillant (31) ; un pont redresseur (33) de la tension aux bornes du circuit oscillant (31) ; un oscillateur commandé en tension (39) de fourniture d'une fréquence de référence (f) ; et dans lequel ledit oscillateur est alimenté et commandé par une tension fonction d'une tension de sortie (Vout) du pont redresseur (33).

## Description

### Domaine technique

La présente description concerne de façon générale les circuits électroniques et, plus particulièrement, les transpondeurs électromagnétiques, étiquettes électroniques (TAG) et autres dispositifs de communication en champ proche. La présente description s'applique plus particulièrement aux dispositifs électroniques intégrant un circuit de communication en champ proche (NFC - Near Field Communication).

### Technique antérieure

Les systèmes de communication à transpondeurs électromagnétiques sont de plus en plus fréquents, en particulier depuis le développement des technologies de communication en champ proche selon la norme ISO 14493 ou le forum NFC.

Ces systèmes exploitent un champ électromagnétique radiofréquence émis par un dispositif (terminal ou lecteur) pour communiquer avec un autre dispositif (carte).

Afin d'optimiser la qualité de la communication, la fréquence de résonance d'un circuit oscillant du dispositif captant un champ est généralement ajustée (accordée) grâce à des éléments capacitifs et/ou résistifs de valeurs réglables.

### Résumé de l'invention

Il existe un besoin d'amélioration des dispositifs de communication en champ proche notamment pour tenir compte de variations d'amplitude de la tension récupérée aux bornes d'un circuit oscillant excité par un champ électromagnétique.

Un mode de réalisation vise à réduire tout ou partie des inconvénients des circuits de communication en champ proche connus.

Un mode de réalisation prévoit un dispositif de communication en champ proche comportant :
un circuit oscillant ;
un pont redresseur de la tension aux bornes du circuit oscillant ; et
un oscillateur commandé en tension de fourniture d'une fréquence de référence,
dans lequel ledit oscillateur est alimenté et commandé par une tension fonction d'une tension de sortie du pont redresseur.

Selon un mode de réalisation, le dispositif comporte en outre un circuit de régulation de ladite tension de sortie du pont redresseur.

Selon un mode de réalisation, le dispositif comporte en outre un ou plusieurs circuits numériques alimentés à partir de la tension de sortie du pont redresseur.

Selon un mode de réalisation, l'oscillateur est alimenté et commandé directement par la tension fournie par le pont redresseur.

Selon un mode de réalisation, le ou lesdits circuits numériques sont alimentés par ledit circuit de régulation de la tension de sortie du pont redresseur.

Selon un mode de réalisation, l'oscillateur est alimenté et commandé par ledit circuit de régulation de la tension de sortie du pont redresseur.

Selon un mode de réalisation, le ou lesdits circuits numériques sont alimentés directement par la tension fournie par le pont redresseur.

Selon un mode de réalisation, ledit circuit de régulation régule la tension d'alimentation et de commande de l'oscillateur en fonction de la tension aux bornes du circuit oscillant.

Selon un mode de réalisation, le dispositif comporte en outre un circuit limiteur de la tension aux bornes du circuit oscillant.

Procédé de régulation de la consommation d'un transpondeur électromagnétique dans lequel une fréquence de fonctionnement de circuits numériques du transpondeur est fonction d'une tension aux bornes d'un circuit oscillant du transpondeur.

Selon un mode de réalisation, ladite fréquence de fonctionnement est fournie par un oscillateur commandé en tension à partir d'une tension de sortie d'un pont redresseur de la tension aux bornes du circuit oscillant.

Selon un mode de réalisation, lesdits circuits numériques sont alimentés par une tension régulée à partir de la tension de sortie du pont redresseur.

Selon un mode de réalisation, ledit oscillateur est alimenté et commandé directement par la tension de sortie du pont redresseur.

Selon un mode de réalisation, ledit oscillateur est alimenté et commandé par une tension régulée à partir de la tension de sortie du pont redresseur.

Selon un mode de réalisation, les circuits numériques sont alimentés directement par la tension de sortie du pont redresseur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon très schématique et sous forme de blocs, un exemple de système de communication en champ proche du type auquel s'appliquent les modes de réalisation décrits ;
la figure 2 représente, de façon très schématique et sous forme de blocs, un mode de réalisation d'un dispositif de communication en champ proche ; et
la figure 3 représente, de façon très schématique et sous forme de blocs, un autre mode de réalisation d'un dispositif de communication en champ proche.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les applications des dispositifs de communication en champ proche n'ont pas été détaillées, les modes de réalisation décrits étant compatibles avec les applications usuelles de tels dispositifs. De plus, les modes de réalisation décrits visant plus particulièrement le transpondeur ou le dispositif excité par un champ magnétique, le fonctionnement du terminal de génération d'un champ électromagnétique, n'a pas été détaillé, les modes de réalisation décrits étant compatibles avec les fonctionnements usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

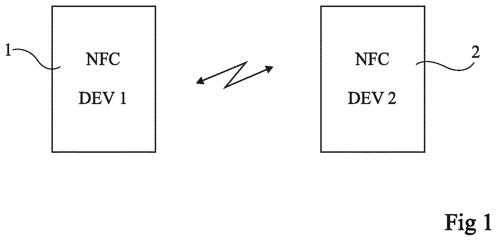

La figure 1 est une représentation très schématique et sous forme de blocs d'un exemple de système de communication en champ proche du type auquel s'appliquent, à titre d'exemple, des modes de réalisation décrits.

On suppose le cas de deux dispositifs électroniques similaires, par exemple deux téléphones mobiles, mais tout ce qui va être décrit s'applique plus généralement à tout système dans lequel un transpondeur capte un champ électromagnétique rayonné par un lecteur, borne ou terminal. Pour simplifier, on fera référence à des dispositifs NFC pour désigner des dispositifs électroniques intégrant des circuits de communication en champ proche.

Deux dispositifs NFC 1 (NFC DEV1) et 2 (NFC DEV2) sont susceptibles de communiquer par couplage électromagnétique en champ proche. Selon les applications, pour une communication, un des dispositifs fonctionne en mode dit lecteur tandis que l'autre fonctionne en mode dit carte, ou les deux dispositifs communiquent en mode poste à poste (peer to peer - P2P) . Chaque dispositif comporte divers circuits électroniques, parmi lesquels un circuit constituant une interface de communication en champ proche, ou interface NFC, entre le dispositif NFC et l'extérieur. Cette interface sert entre autres, en mode lecteur, à générer un signal radiofréquence émis à l'aide d'une antenne et, en mode carte, à décoder un signal radiofréquence capté. Le champ radiofréquence généré par l'un des dispositifs est capté par l'autre dispositif qui se trouve à portée et qui comporte également une antenne.

Pour simplifier, on fera par la suite référence à un terminal pour désigner un dispositif émettant un champ électromagnétique (par exemple une borne de lecture d'étiquettes électroniques, un dispositif NFC fonctionnant en mode lecteur, etc.) et à un transpondeur pour désigner un dispositif destiné à capter ce champ (par exemple une étiquette électronique, un dispositif NFC fonctionnant en mode carte, etc.).

Un transpondeur comporte une antenne faisant partie d'un circuit oscillant (par exemple un circuit oscillant parallèle constitué de l'antenne et d'un élément capacitif en parallèle) destiné à être excité en présence d'un champ électromagnétique. Ce circuit oscillant est généralement accordé sur une fréquence d'excitation d'un circuit oscillant d'un terminal destiné à générer le champ électromagnétique. Par exemple, les circuits oscillants sont accordés sur une fréquence de 13,56 MHz. La communication, dans le sens terminal vers transpondeur, s'effectue généralement en modulant l'amplitude et/ou la phase du signal radiofréquence généré par le terminal, donc du champ électromagnétique. La communication, dans le sens transpondeur vers terminal, s'effectue généralement en modulant (rétromodulation) la charge que constituent les circuits du transpondeur sur son circuit oscillant. Pour simplifier, les circuits de détection d'amplitude et/ou de phase (démodulation) ainsi que de rétromodulation n'ont pas été détaillés, les modes de réalisation décrits étant compatibles avec les circuits usuels de démodulation et de rétromodulation.

Dans certaines applications, le transpondeur extrait, du champ électromagnétique, l'énergie nécessaire aux circuits électroniques qu'il comporte.

Une des contraintes de fonctionnement d'un transpondeur est que la tension récupérée aux bornes du circuit oscillant est susceptible de varier fortement en fonction du couplage entre les antennes des circuits oscillants du terminal et du transpondeur, ce couplage étant, entre autres, fonction de la distance séparant les circuits oscillants l'un de l'autre.

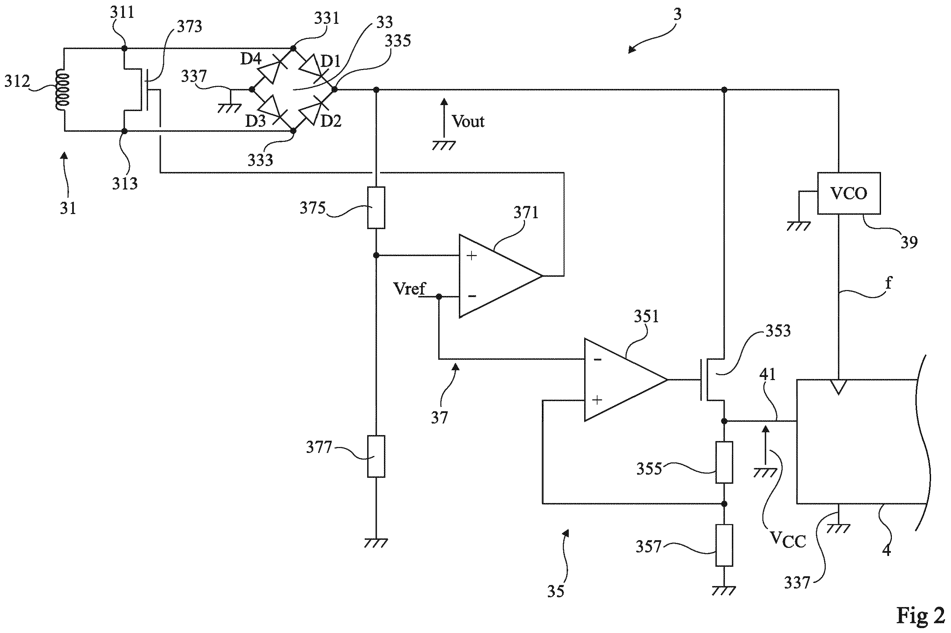

La figure 2 représente, de façon très schématique et sous forme de blocs, un mode de réalisation d'un dispositif 3 de communication en champ proche. Ce dispositif constitue un transpondeur ou la partie transpondeur (ou carte) d'un dispositif mixte.

Le dispositif 3 équipe, par exemple, l'un des dispositifs 1 et 2 de la figure 1, ou les deux.

Le transpondeur 3 comporte un circuit oscillant 31 dont un élément inductif, constitué d'une antenne 312, est destiné à capter un champ électromagnétique. Dans l'exemple de la figure 2, on suppose qu'un élément capacitif du circuit oscillant est constitué par des capacités parasites. En variante, un condensateur (par exemple de capacité variable afin d'ajuster l'accord du circuit oscillant) est connecté en parallèle sur l'antenne 312.

Des bornes 311 et 313 du circuit oscillant, correspondant aux bornes de l'antenne 312, sont reliées, de préférence connectées, à des bornes 331 et 333 d'entrée alternative d'un pont redresseur 33 dont des bornes de sortie redressée 335 et 337 fournissent une tension continue Vout destinée à alimenter les circuits électroniques du transpondeur. La borne 337 définit, dans l'exemple représenté, un potentiel de référence (la masse). Un condensateur (non représenté) de lissage de la tension Vout est généralement présent entre les bornes 335 et 337. Le pont redresseur 33 est, selon les réalisations, simple ou double alternance. Dans l'exemple de la figure 2, on suppose le cas d'un pont double alternance dont deux diodes D1 et D2 connectent respectivement les bornes 331 et 333 à la borne 335 avec leurs cathodes côté borne 335, et dont deux diodes D3 et D4 connectent respectivement les bornes 331 et 335 à la borne 337 avec leurs anodes côté borne 337.

La tension de sortie Vout du pont redresseur 33 est régulée par un régulateur linéaire 35, ou régulateur shunt. Dans l'exemple schématique représenté en figure 2, le régulateur 35 est basé sur un comparateur analogique 351 d'une information représentative d'une tension Vcc, par rapport à une tension de référence Vref. La tension Vcc constitue une tension de sortie servant à alimenter un ou plusieurs circuits électroniques du transpondeur, symbolisés par un bloc 4 en figure 2. Dans l'exemple illustré en figure 2, le comparateur 351 pilote (est relié à, de préférence connecté à) la grille d'un transistor MOS 353 reliant, de préférence connectant, la borne 335 à une borne 41 de fourniture du potentiel Vcc (supposé référencé par rapport à la masse 337). Une entrée, par exemple directe + (non inverseuse), du comparateur 351 reçoit une information représentative de la tension Vcc tandis que son autre entrée - (inverseuse) reçoit la tension de référence Vref. La tension de référence Vref est par exemple fournie par un circuit de type bandgap. Par exemple, le point milieu d'une association en série de deux résistances 355 et 357, connectant les bornes 41 et 337 et formant un pont diviseur résistif, est connecté à la borne + du comparateur 351.

Le transpondeur 3 comporte également, de préférence, un circuit 37 de protection contre des surtensions. Ce circuit 37 comporte un comparateur analogique 371 d'une information représentative de la tension Vout (donc de la tension non régulée) en sortie du pont redresseur 33 par rapport à une tension de référence Vref. Dans l'exemple illustré en figure 2, le comparateur 371 pilote (est relié à, de préférence connecté à) la grille d'un transistor MOS 373 reliant, de préférence connectant, les bornes 311 et 313 du circuit oscillant. Une entrée, par exemple directe + (non inverseuse), du comparateur 371 reçoit une information représentative de la tension Vcc tandis que son autre entrée - (inverseuse) reçoit la tension de référence Vref. La tension de référence Vref est par exemple la même que celle utilisée par le comparateur 351. Par exemple, le point milieu d'une association en série de deux résistances 375 et 377, connectant les bornes 335 et 337 et formant un pont diviseur résistif, est connecté à la borne + du comparateur 371. Le rôle du circuit 37 est de moduler la valeur de la résistance drain-source à l'état passant du transistor 373 pour limiter (écrêter) la surtension aux bornes de l'antenne à une valeur choisie en fonction de la tension que peuvent supporter les circuits connectés en aval. Ainsi, seul le transistor 373 et, le cas échéant, le condensateur du circuit oscillant ont besoin de supporter les surtensions, le reste des circuits ne voyant qu'une tension limitée. Structurellement, le circuit 37 a la même constitution qu'un régulateur shunt.

Selon les applications visées par la présente description, les circuits 4 du transpondeur comportent, entre autres, des circuits numériques pilotés à une fréquence f.

Selon les modes de réalisation décrits, on prévoit d'ajuster la fréquence f de fonctionnement des circuits 4 du transpondeur en fonction de la tension Vout récupérée aux bornes du circuit oscillant. Un tel ajustement permet d'adapter la consommation du transpondeur à l'énergie disponible. En effet, plus les circuits numériques 4 du transpondeur 3 sont pilotés à une fréquence f élevée, plus ils consomment et plus ils participent à réduire la surtension aux bornes du circuit oscillant 31. A l'inverse, réduire la fréquence f de base de fonctionnement des circuits numériques 4 du transpondeur 3 lorsque la tension récupérée aux bornes de l'antenne diminue permet de préserver la téléalimentation du transpondeur sans perte de communication. Ainsi, ajuster la fréquence de fonctionnement optimise le rendement en tirant profit du maximum d'énergie possible tout en préservant une protection des circuits contre des tensions trop élevées. En fait, les circuits 4 du transpondeur 3 font partie de la charge du circuit oscillant 31. Leur consommation influe donc sur la tension aux bornes du circuit oscillant 31. Accroître la fréquence de fonctionnement, donc la consommation, des circuits 4 réduit la tension aux bornes du circuit 31. On perd alors moins d'énergie par dissipation dans le transistor 373 (ou autre circuit shunt équivalent).

On aurait pu penser exploiter l'information de tension utilisée par le comparateur 371 pour, par l'intermédiaire d'un convertisseur analogique numérique, fournir une consigne numérique à un circuit numérique de génération d'horloge que comportent généralement les circuits 4. Toutefois, cela risquerait de fournir un système instable en raison des oscillations que cela introduirait en aval du pont redresseur entre deux instants d'ajustement de la fréquence.

Selon les modes de réalisation décrits, on prévoit d'utiliser un oscillateur commandé en tension 39 (VCO) de façon analogique pour fournir la fréquence de base de fonctionnement des circuits 4 du transpondeur 3. Cet oscillateur commandé en tension est alimenté à partir de la tension Vout de sortie du pont redresseur 33. La fréquence f fournie par l'oscillateur 39 constitue une fréquence de base qui peut ensuite être divisée par les circuits du bloc 4.

Dans le mode de réalisation de la figure 2, on combine l'utilisation d'un régulateur linéaire 35 (régulateur shunt) pour fournir la tension Vcc d'alimentation des circuits du transpondeur, avec l'utilisation d'un oscillateur commandé et alimenté directement par la tension Vout (non régulée). Cela permet d'ajuster la consommation des circuits 4 en fonction de l'énergie disponible et optimise ainsi le fonctionnement.

Bien que cela n'ait pas été illustré, les comparateurs 351 et 371 peuvent, dans le mode de réalisation de la figure 2, être alimentés par la tension Vout ou par la tension Vcc.

Il est en outre possible de faire varier la consommation des circuits 4 en activant certaines fonctions lorsque l'énergie disponible est suffisante, c'est-à-dire lorsque la fréquence f est relativement élevée (par rapport à une valeur de la fréquence sous moindre énergie).

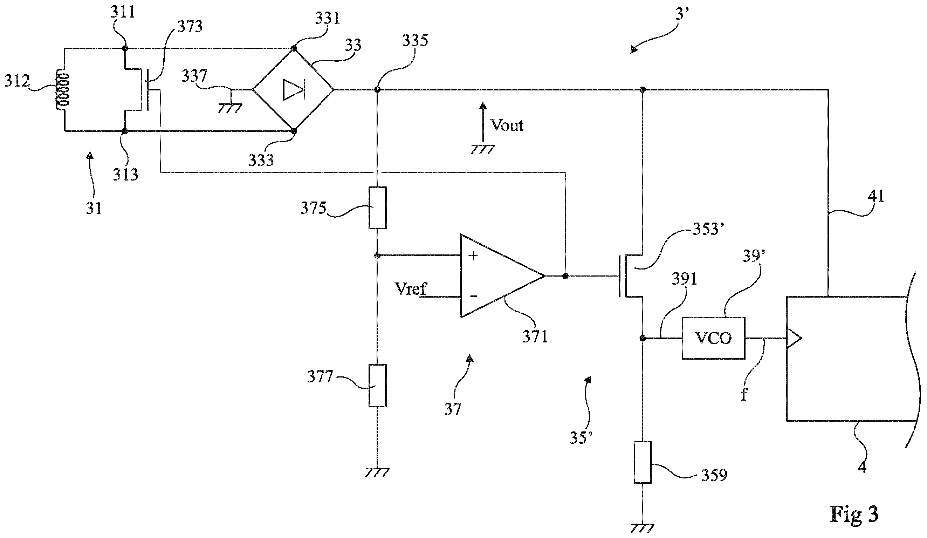

La figure 3 représente, de façon très schématique et sous forme de blocs, un autre mode de réalisation d'un transpondeur 3' utilisant un oscillateur commandé en tension pour faire varier la fréquence de base f de circuits 4 du transpondeur 3' en fonction de la tension disponible en sortie du circuit oscillant.

On retrouve le circuit oscillant 31, le pont redresseur 33 et le circuit 37 de protection.

Toutefois, dans le mode de réalisation de la figure 3, les circuits 4 sont alimentés directement par la tension Vout de sortie du pont redresseur (de préférence lissée par un condensateur non représenté). Ainsi, la borne 41 est reliée, de préférence connectée, à la borne 335.

Selon ce mode de réalisation, la régulation de la tension Vout est directement obtenue en faisant varier la fréquence f de fonctionnement des circuits numériques du transpondeur. Ainsi, un oscillateur commandé en tension 39', à commande analogique, est commandé et alimenté par la sortie d'un régulateur linéaire (ou régulateur shunt) 35'. Dans l'exemple de la figure 3, le régulateur 35' comporte un transistor MOS 353' entre la borne 335 et une borne 391 de commande et d'alimentation de l'oscillateur 39', et une résistance 359 reliant la borne 391 à la masse 337. Le transistor 353' est, dans cet exemple, piloté par le comparateur 371 et a donc sa grille reliée, de préférence connectée, à la sortie du comparateur 371.

Dans ce mode de réalisation, la commande de l'oscillateur 39' par un régulateur shunt 35' permet de réguler indirectement la tension d'alimentation appliquée à la borne 41 par la fréquence de fonctionnement.

En variante, on prévoit un autre comparateur (non représenté) pour commander le transistor 353' en prélevant une information sur la tension Vout pour le commander.

Dans l'exemple de la figure 3, le pont redresseur 33 est symbolisé par un bloc. Il peut être, comme en figure 2, simple ou double alternance.

Un avantage des modes de réalisation décrits est qu'ils tirent profit d'une moindre consommation d'un oscillateur commandé en tension par rapport à celle d'un convertisseur analogique-numérique.

Un autre avantage des modes de réalisation décrits est qu'ils sont compatibles avec un fonctionnement du transpondeur dans différents modes de puissance.

Un autre avantage des modes de réalisation décrits est que, tout en optimisant la consommation du transpondeur, on préserve la fonction de protection assurée par le circuit 37.

Différents types d'oscillateurs commandés en tension peuvent être utilisés pour l'oscillateur 39 ou 39'. De préférence, on utilise un oscillateur en anneau qui présente l'avantage de sa simplicité et d'éviter le recours à un composant inductif.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art. En particulier, le choix des fréquences de fonctionnement du transpondeur dépend de l'application.

Enfin, la mise en oeuvre pratique des modes de réalisation et variantes décrits est à la portée de l'homme du métier à partir des indications fonctionnelles données ci-dessus. En particulier, on pourra prévoir d'autres montages de fourniture de la tension de commande (ou d'alimentation) de l'oscillateur commandé en tension, pourvu que cette tension soit fonction de la tension aux bornes du circuit oscillant 31.

## Revendications

1. Dispositif de communication en champ proche comportant :
un circuit oscillant (31) ;
un pont redresseur (33) de la tension aux bornes du circuit oscillant (31) ;
un oscillateur commandé en tension (39 ; 39') de fourniture d'une fréquence de référence (f) ; et
dans lequel ledit oscillateur (39 ; 39') est alimenté et commandé par une tension fonction d'une tension de sortie (Vout) du pont redresseur (33).

2. Dispositif selon la revendication 1, comportant en outre un circuit (35 ; 35') de régulation de ladite tension de sortie (Vout) du pont redresseur (33).

3. Dispositif selon la revendication 1 ou 2, comportant en outre un ou plusieurs circuits numériques (4) alimentés à partir de la tension de sortie (Vout) du pont redresseur (33) .

4. Dispositif selon l'une quelconque des revendications 1 à 3, dans lequel l'oscillateur (39) est alimenté et commandé directement par la tension (Vout) fournie par le pont redresseur (33).

5. Dispositif selon les revendications 2 à 4, dans lequel le ou lesdits circuits numériques (4) sont alimentés par ledit circuit de régulation (35) de la tension de sortie (Vout) du pont redresseur (3).

6. Dispositif selon la revendication 2, dans lequel l'oscillateur (39') est alimenté et commandé par ledit circuit de régulation (35') de la tension de sortie (Vout) du pont redresseur (33).

7. Dispositif selon les revendications 3 et 6, dans lequel le ou lesdits circuits numériques (4) sont alimentés directement par la tension (Vout) fournie par le pont redresseur (33).

8. Dispositif selon la revendication 6 ou 7, dans lequel ledit circuit de régulation (35') régule la tension d'alimentation et de commande de l'oscillateur (39') en fonction de la tension aux bornes du circuit oscillant (31).

9. Dispositif selon l'une quelconque des revendications 1 à 8, comportant en outre un circuit limiteur (37) de la tension aux bornes du circuit oscillant (31).

10. Procédé de régulation de la consommation d'un transpondeur électromagnétique (3 ; 3') dans lequel une fréquence de fonctionnement (f) de circuits numériques (4) du transpondeur est fonction d'une tension aux bornes d'un circuit oscillant (31) du transpondeur.

11. Procédé selon la revendication 10, dans lequel ladite fréquence de fonctionnement est fournie par un oscillateur commandé en tension à partir d'une tension de sortie (Vout) d'un pont redresseur (33) de la tension aux bornes du circuit oscillant (31).

12. Procédé selon la revendication 11, dans lequel lesdits circuits numériques (4) sont alimentés par une tension régulée à partir de la tension de sortie du pont redresseur (33) .

13. Procédé selon la revendication 11 ou 12, dans lequel ledit oscillateur (39) est alimenté et commandé directement par la tension de sortie (Vout) du pont redresseur (33).

14. Procédé selon la revendication 11, dans lequel ledit oscillateur (39') est alimenté et commandé par une tension régulée à partir de la tension de sortie du pont redresseur (33) .

15. Procédé selon la revendication 11 ou 14, dans lequel les circuits numériques sont alimentés directement par la tension de sortie (Vout) du pont redresseur (33).
